Europäisches Patentamt

European Patent Office

Office européen des brevets

(11) Publication number: **0 278 159**
**A2**

## (12) EUROPEAN PATENT APPLICATION

(21) Application number: **87310070.5**

(51) Int. Cl.⁴: **H01L 21/76**

(22) Date of filing: **13.11.87**

The application is published incomplete as filed (Article 93 (2) EPC). The point in the description or the claim(s) at which the omission obviously occurs has been left blank.

The title of the invention has been amended (Guidelines for Examination in the EPO, A-III, 7.3).

(30) Priority: **19.11.86 GB 8627666**

(43) Date of publication of application:
**17.08.88 Bulletin 88/33**

(84) Designated Contracting States:
**DE FR NL**

(71) Applicant: **PLESSEY OVERSEAS LIMITED**
**Vicarage Lane**
**Ilford Essex IGI 4AQ(GB)**

(72) Inventor: **Roberts, Martin Ceredig**
**41 Highfields**
**Towcester Northants NN12 7EY(GB)**

(74) Representative: **Field, Howard John et al**
**THE PLESSEY COMPANY plc Intellectual**
**Property Department Vicarage Lane**
**Ilford Essex IG1 4AQ(GB)**

(54) **Method of manufacturing a semiconductor device comprising an isolation structure.**

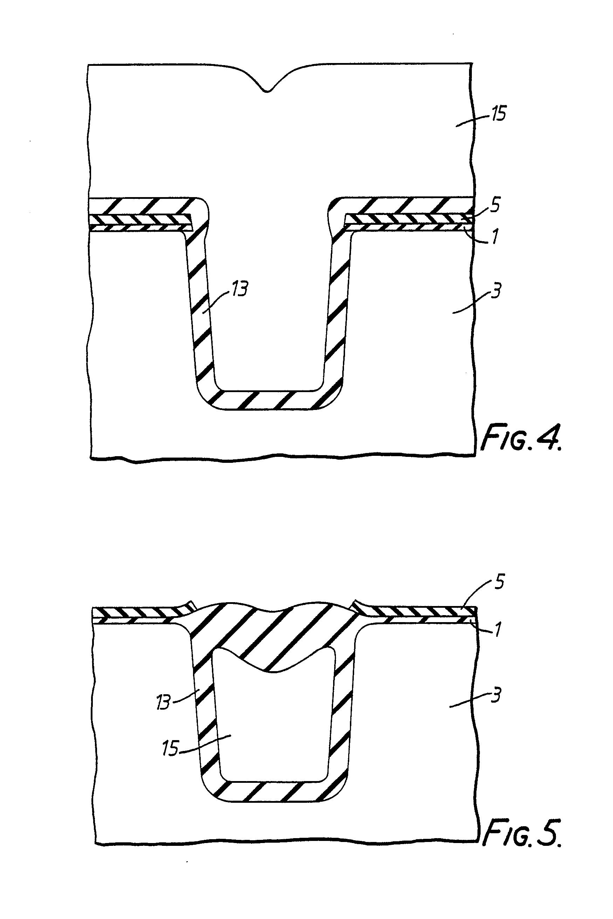

(57) A method (fig. 3) where following etch definition of a trench (9) in silicon, the walls of this trench (9) are coated with a layer of polysilicon (11) and the latter oxidised (13). The trench (9) is then infilled e.g. with deposited polysilicon (15).

The walls of the trench (9) may be oxidised to provide a thin oxide film (12) prior to polysilicon (11) deposition.

EP 0 278 159 A2

# METHOD OF SEMICONDUCTOR DEVICE MANUFACTURE

## Technical Field

The prsent invention concerns improvements in or relating to methods of semiconductor device manufacture in particular methods of manufacturing devices having trench isolated structure.

## Background Art

Trench isolated structure has been used for device isolation on silicon wafers. It is a problem in conventional processing techniques that the production of trench isolating oxide - e.g. by thermal oxidation of trench wall silicon - often leads to an increase in or to introduction of substantial defect density in the immediate vicinity of the trench oxide. This has as a consequence the effect of increasing leakage current flow for devices provided adjacent to the trench, reducing device performance reliability and yield.

## Disclosure of the Invention

The method of the present ivnention is intended to provide a solution to the problem aforesaid.

According to this invention there is provided a method of semiconductor device manufacture comprising the following steps:-
providing a substrate of single crystal silicon material having a thin covering of nitride and over this a layer of masking material;
etching in this composite structure a trench extending into the silicon substrate;
removing the masking material;
depositing on the exposed nitride layer, and exposed silicon trench walls, a layer of polysilicon;
oxidising the layer of polysilicon; and,
in-filling the trench.

It is noted that in the method aforesaid a sacrificial layer of polysilicon is used in producing the trench wall oxide. This acts as a temporary stress-relief layer during oxidation and leads to a reduction in the stress in the silicon substrate material.

The trench filling may comprise polysilicon. In this preferred case, little stress is introduced during thermal cycling, the difference in the thermal expansion coefficients of silicon and polysilicon being small. Further advantages will become apparent from the description that follows.

## Brief Introduction of the Drawings

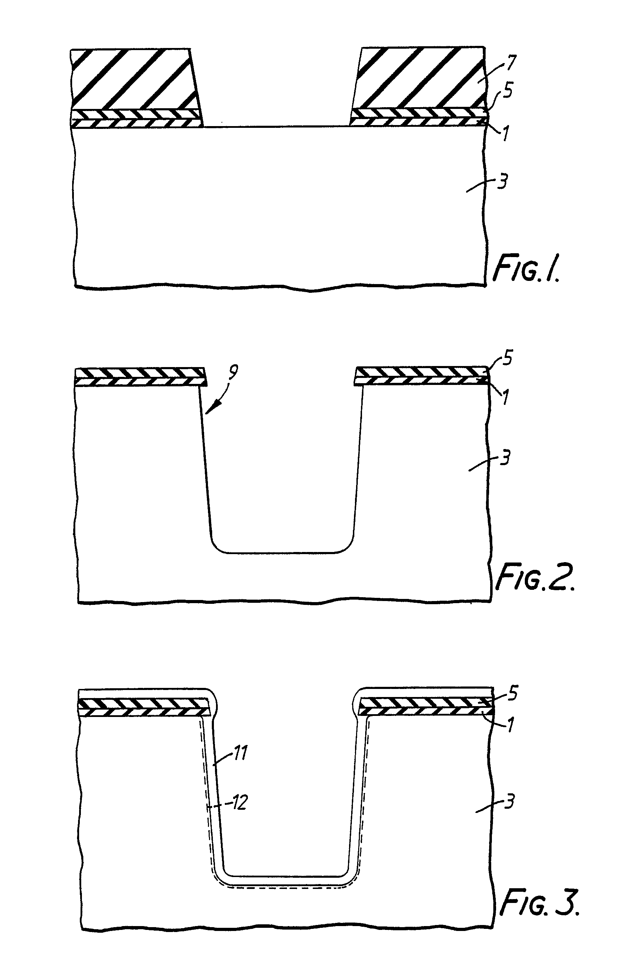

In the drawings accompanying this specificaion:-
Figures 1 to 5 are cross-section views of a silicon device at succesive stages of its manufacture by the method described herein.

## Description of an Embodiment

So that this invention may be better understood, an embodiment thereof will now be described with reference to the drawings. This description is given by way of example only.

At the start of the method, a thin layer of oxide 1 (c.300Å) is grown at the surface of a single crystal silicon substrate 3 by thermal oxidation. Subsequently a thin layer 5 of silicon nitride (c.5000Å) is deposited on the thin oxide layer 1 and a thick silicon oxide masking material layer 7 (c.4000Å) deposited upon this. This layer 7 is optional, but is included here to permit the use of a high power density plasma. A suitable resist is spun onto the surface of the deposited oxide 7 and patterned photolithographically. The composite then formed is then plasma etched to define a trench mask and the resist removed by ashing ...... See Figure 1.

The composite is then dry etched by a high power density plasma to define a trench 9 in the silicon substrate 3. The deposited oxide layer 7 is then removed using a buffered hydrofluoric acid (HF) solution as etchant. The exposed silicon surface of the trench 9 is then lightly etched (c.500Å) using a wet chemical etch to remove surface damage introduced during the dry etch steps of this method ...... See Figure 2. (Optionally, a thin film of oxide, 12 (c.400Å) may be grown at this stage, e.g. at a temperature of 950°C. This obviates any problems that otherwise can arise due to the entrapment of impurities at the silicon/polysilicon interface).

As a key step in this method, a thin sacrificial layer 11 of polysilicon material (c.500Å) is then deposited to cover the walls of the trench 9 and to cover the exposed surface of the nitride layer 5 ...... See Figure 3.

Following deposition the polysilicon layer 11 is then thermally oxidised. This step is performed at a temperature in the range 950° - 1050°C. Below this range of temperature, oxide viscosity would be low and would provide no means of relieving stress. Above this range, dopant redistribution effects would be unacceptable. This step of the method is also controlled to ensure that little if any of the adjacent wall silicon is oxidised, thereby to minimise any further dopant redistribution effects. During this step of the process the layer 11 expands providing a lighter density layer 13 of isolation oxide (c.1200Å).

The trench 9 is then infilled by depositing polysilicon material 15 ...... See Figure 4.

Ultimately, surplus polysilicon material is removed by etch-back, detection of the oxide layer 13 being used as end-point. The oxide 13 remaining above the nitride layer 5 is then removed using a buffered HF acid solution and the exposed in-fill polysilicon exidised ...... See Figure 5.

The use of sacrificial polysilicon in this method contributes improvements as follows:-

i) Both the wet silicon etch and polysilicon layer rounds trench corners leading to a reduction in stress and hence to a reduction in the defects generated during oxidation;

ii) The polysilicon acts as a temporary stress-relief layer during oxidation leading to a reduction in the stress in the single crystal silicon;

iii) The polysilicon layer also maintains the linewidth of the trench since only a few hendred Angstroms of silicon is consumed during oxidation; and,

iv) the oxide formed above the nitride during the oxidation of the polysilicon layer acts as an ideal end point during the subsequent etch back of the polysilicon infill.

The low defect density trench isolated structure can be used to electrically isolate MOS devices and Bipolar devices. The trench structure could also be used as a capacitor in an integrated circuit. Such a capacitor would have a large capacitance to chip area ratio enabling the packing density to remain high.

## Claims

1. A method of semiconductor device manufacture including the steps of:-
providing a substrate (3) of single crystal silicon material having a thin layer covering (5) of nitride and over this a layer (7) of masking material;
etching in this composite structure (3, 5, 7) a trench (9) extending into the silicon substrate (3); and
removing the masking material (7);
which method is characterising by the following steps:-
depositing on the exposed nitride layer (5), and exposed silicon trench walls and base (9), a conformal thin layer (11) of polysilicon;

oxidising the layer (11) of polysilicon at a temperature in the range 950° - 1050°C; and finally,
in-filling the trench.

2. A method, as claimed in claim 1, wherein said masking material (7) is of deposited thick oxide.

3. A method, as claimed in either one of the preceding claims, wherein a thin film (12) of oxide is grown thermally at the exposed silicon trench walls and base (9) prior to the step of .

.

.

immediately preceded by a wet chemical light etch step that is performed to remove any damage at the surface of the etched trench (9).

5. A method, as claimed in any one of the preceding claims, wherein finally polysilicon material (15) is deposited to infill the trench (9).

6. A method, as claimed in Claim 5, wherein the infill polysilicon material (15) is cut back to the level of the nitride layer (5), and the surface thereof is oxidised (13).

FIG./.

FIG.2.

FIG.3.

0 278 159

FIG.4.

15

5

1

13

3

FIG.5.

5

1

13

15

3